(19) Europäisches Patentamt / European Patent Office / Office européen des brevets

(11) **EP 4 358 353 A1**

(12) **EUROPEAN PATENT APPLICATION**
published in accordance with Art. 153(4) EPC

(43) Date of publication:
**24.04.2024 Bulletin 2024/17**

(21) Application number: **22899103.0**

(22) Date of filing: **25.11.2022**

(51) International Patent Classification (IPC):
*H02J 7/00* (2006.01)   *G01R 31/389* (2019.01)
*H01M 10/44* (2006.01)   *H01M 10/42* (2006.01)

(52) Cooperative Patent Classification (CPC):
**G01R 31/389; H01M 10/42; H01M 10/44;**
**H02J 7/00;** Y02E 60/10

(86) International application number:
**PCT/KR2022/018891**

(87) International publication number:
**WO 2023/096421 (01.06.2023 Gazette 2023/22)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **26.11.2021   KR 20210165803**
**23.12.2021   KR 20210186359**

(71) Applicant: **Samsung Electronics Co., Ltd.**
**Suwon-si, Gyeonggi-do 16677 (KR)**

(72) Inventor: **LEE, Sangheon**
**Suwon-si, Gyeonggi-do 16677 (KR)**

(74) Representative: **Gulde & Partner**
**Patent- und Rechtsanwaltskanzlei mbB**
**Wallstraße 58/59**
**10179 Berlin (DE)**

(54) **METHOD FOR CONTROLLING CURRENT RATIO OF MULTIPLE BATTERY CELLS CONNECTED IN PARALLEL, AND CONTROL SYSTEM THEREOF**

(57)   Disclosed is a battery control system including a first battery cell, a second battery cell connected in parallel to the first battery cell, a first impedance controller connected in series to the first battery cell, a second impedance controller connected in series to the second battery cell, and a control circuit electrically connected to the first battery cell, the second battery cell, the first impedance controller, and the second impedance controller, wherein the control circuit is configured to: measure a potential difference between the first battery cell and the second battery cell; determine whether a magnitude of the potential difference is included in a first range; and, based on determining that the magnitude of the potential difference is determined not included in the first range, control one of the first impedance controller and the second impedance controller, so as to control a ratio by which the entire current introduced into the battery control system is distributed to the first battery cell and the second battery cell, to be included in a predetermined range.

FIG.4

**Description**

[Technical Field]

The disclosure relates to a method for, in a battery device including multiple battery cells connected in parallel, consistently controlling a ratio between the currents flowing in the multiple battery cells, and a control circuit therefor.

[Background Art]

Lithium ion batteries that are chargeable and/or dischargeable are being widely used as energy storage devices for driving portable electronic devices due to advantages thereof, such as high energy density and high output voltage. A lithium ion battery for driving a portable electronic device may be manufactured by connecting multiple battery cells in series or parallel so as to satisfy various form factors and/or charging specifications of the portable electronic device.
In a case of a battery (or a battery pack or a battery device) manufactured by connecting multiple battery cells in parallel, the total current introduced into the battery may not be properly distributed to the battery cells connected in parallel. For example, in a case in which an impedance for one cell is larger in a battery including two battery cells connected in parallel, the current introduced into the corresponding cell may be excessively low. On the other hand, the current introduced into a cell having a small impedance is excessively large, and thus the smaller impedance cell may be overcharged, and may be charged at a high C-rate. A cell exposed to overcharging and/or high C-rate charging undergoes accelerated deterioration and quickly reaches its life limit, and thus the life of the entire battery may be shortened. In addition, there may occur an inrush current from a relatively high voltage battery cell to a low voltage battery cell, and a high inrush current may damage a protection circuit of the battery.
Accordingly, for a battery including multiple battery cells connected in parallel, various balancing methods for controlling a ratio between the currents flowing in the multiple battery cells have been proposed.

[Disclosure of Invention]

[Technical Problem]

As a conventional balancing method for controlling a current ratio between multiple battery cells, a method of performing self-discharging using a self-discharge circuit connected in parallel to a battery cell having a high charge amount, or variably adjusting a magnitude of a serial resistor element connected to a battery cell to be balanced has been proposed. The above methods have been designed in terms of steps that may be taken after occurrence of a charge amount difference between multiple battery cells connected in parallel.
However, in a case in which a charge amount difference already incurred between multiple battery cells connected in parallel is removed, a charge amount loss may occur due to discharge, or excessive current may be introduced or discharged to or from a battery cell which is not subject to be balanced. In addition, a separate external battery management system (BMS) may be required for balancing, but may be difficult to be applied in a small portable electronic device.
Various embodiments disclosed herein propose a battery control method and/or control system by which a charge and/or discharge current ratio between multiple battery cells is consistently maintained, whereby occurrence of a charge amount different between the battery cells is prevented or reduced.

[Solution to Problem]

A battery control system according to an embodiment may include a first battery cell, a second battery cell connected in parallel to the first battery cell, a first impedance controller connected in series to the first battery cell, a second impedance controller connected in series to the second battery cell, and a control circuit electrically connected to the first battery cell, the second battery cell, the first impedance controller, and the second impedance controller, wherein the control circuit may be configured to: measure a potential difference between the first battery cell and the second battery cell; determine whether a magnitude of the potential difference is included in a first range; and, based on determining that the magnitude of the potential difference is determined is not included in the first range, control one of the first impedance controller and the second impedance controller, so as to control a ratio by which the entire current introduced into the battery control system is distributed to the first battery cell and the second battery cell, to be included in a predetermined range.
A battery control method according to an embodiment may include measuring a potential difference between a first battery cell and a second battery cell connected in parallel to the first battery cell, determining whether a magnitude of the potential difference is included in a first range, and, based on determining that the magnitude of the potential difference is determined is not included in the first range, controlling one of a first impedance controller connected in series to the first battery cell and a second impedance controller connected in series to the second battery cell, so as to control a ratio by which an entire current introduced into the battery control system is distributed to the first battery cell and the second battery cell, to be included in a predetermined range.

An electronic device according to an embodiment may include a housing, a first battery cell disposed in the housing, a second battery cell disposed in the housing and connected in parallel to the first battery cell, and a control circuit electrically connected to the first battery cell and the second battery cell, wherein the control circuit may be configured to: measure a first potential difference between the first battery cell and the second battery cell; determine a target voltage range within which the potential difference between the first battery cell and the second battery cell is to be adjusted; determine whether a magnitude of the measured first potential difference is included in the target voltage range; and, based on determining that the magnitude of the first potential difference is not included in the target voltage range, adjust the magnitude of the first potential difference to be included in the target voltage range, thereby controlling a ratio by which an entire current introduced into the battery control system is distributed to the first battery cell and the second battery cell, to be included in a predetermined range.

[Advantageous Effects of Invention]

A battery control system including multiple battery cells connected in parallel according to various embodiments disclosed herein may adjust, in real time, a current distribution ratio between battery cells through adjustment of a potential difference between the battery cells, thereby minimizing, in real time, occurrence of a charge amount difference between the battery cells.

A battery control system including multiple battery cells connected in parallel according to various embodiments disclosed herein may perform control such that, even in a battery configured by heterogeneous battery cells having different capacities, currents are introduced and/or discharged to or from individual battery cells always at the same (or substantially the same) C-rate, and thus may regulate a charging operation for each of battery cells connected in parallel at the level of the entire battery.

Various other effects directly or indirectly recognized herein may be provided.

[Brief Description of Drawings]

FIG. 1 is a block diagram of an electronic device in a network environment according to various embodiments;

FIG. 2 is a diagram illustrating an example of a battery cell equivalent charging circuit employing a dynamic resistance scheme according to a comparative embodiment;

FIG. 3 is a block diagram illustrating a battery control system according to an embodiment;

FIG. 4 is a diagram illustrating an example of a control circuit of a battery control system including multiple battery cells connected in parallel according to an embodiment;

FIG. 5 is a flowchart illustrating a current ratio control method of a battery control system according to an embodiment;

FIG. 6 is a diagram illustrating an example of a control circuit of a battery control system including multiple battery cells connected in parallel according to an embodiment;

FIG. 7 is a flowchart illustrating a current ratio control method of a battery control system according to an embodiment;

FIGS. 8A, 8B, 8C, 8D, 8E, 8F, 8G, and 8H are graphs illustrating a process of controlling a current ratio within a predetermined range in a battery control system according to an embodiment; and

FIGS. 9A and 9B illustrate an example of a battery control system disposed in a foldable electronic device according to an embodiment.

In relation to the description of drawings, the same or similar elements may be indicated by the same or similar reference signs.

[Mode for Carrying out the Invention]

Hereinafter, various embodiments disclosed herein will be described with reference to the accompanying drawings. For convenience of explanation, the size of elements illustrated in the drawings may be exaggerated or reduced, and the disclosure is not necessarily limited to the illustrations.

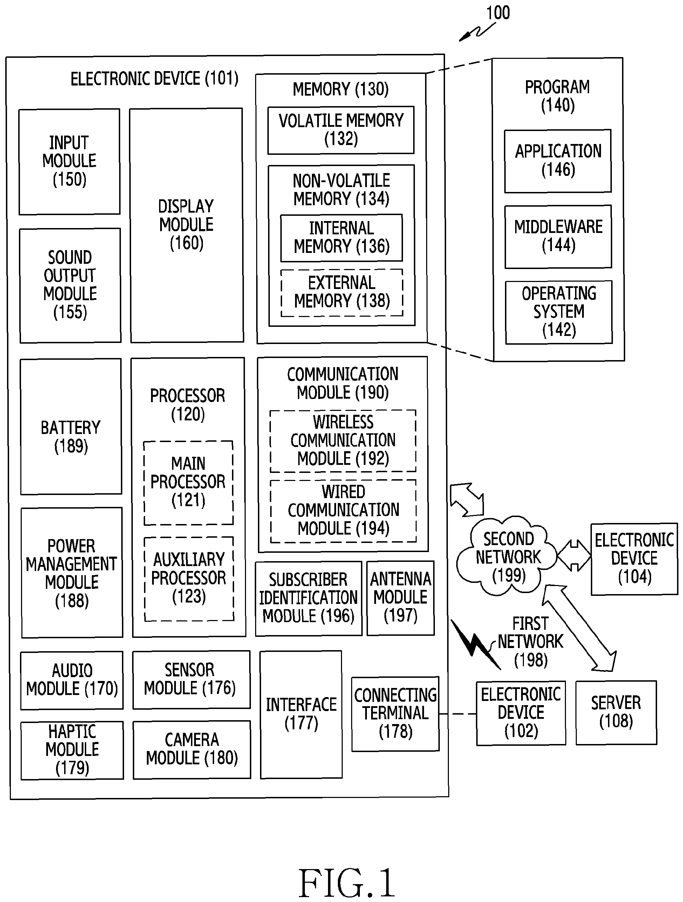

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In various embodiments, at least one of the components (e.g., the connecting terminal 178) may be omitted from the electronic device 101, or one or more other components may be added in the electronic device 101. In various embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of, the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, a home appliance or the like. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and do not limit the components in other aspects (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used in connection with various embodiments of the disclosure, the term "module" may include a unit implemented in hardware, software, firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. The term "non-transitory" storage medium may refer, for example, to a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

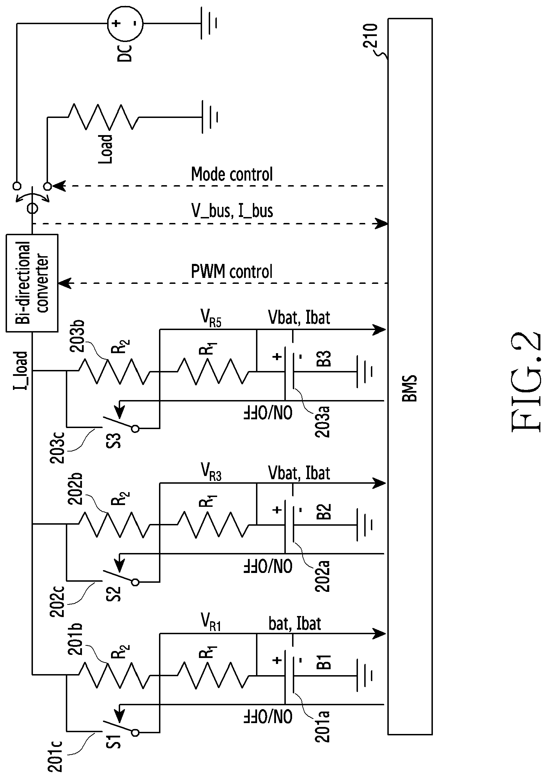

FIG. 2 is a diagram illustrating an example of a battery cell equivalent charging circuit employing a dynamic resistance scheme according to a comparative embodiment.

Referring to FIG. 2, battery cells 201a, 202a, and 203a of a battery cell equivalent charging circuit according to a comparative embodiment may be connected in parallel to each other. The battery cells 201a, 202a, and 203a connected in parallel may include supplementary resistors 201b, 202b, and 203b connected in series to respective branch circuits thereof, and ON/OFF switches 201c, 202c, and 203c connected in parallel to the supplementary resistors 201b, 202b, and 203b. A battery management system (BMS) 210 may identify a battery cell having the highest state of charge (SOC) in a charge state, and identify a battery cell having the lowest SOC in a discharge state. In a charge state, only an ON/OFF switch connected to a battery cell corresponding to the highest SOC may be controlled to be turned off, and in a discharge state, only an ON/OFF switch connected to a battery cell corresponding to the lowest SOC may be controlled to be turned off. Accordingly, in a charge state, a path impedance for a battery cell having the highest SOC is highest, and in a discharge state, a path impedance for a battery cell having the lowest SOC is highest. In addition, in a charge state, the current introduced into a battery cell having the highest SOC is smallest, and in a discharge state, the current discharged from a battery cell having the lowest SOC is smallest.

As a result, a battery cell equivalent charging circuit employing a dynamic resistance scheme according to a comparative embodiment may control a charge speed of a battery cell having the highest SOC to be lowest in a charge state, and control a discharge speed of a battery cell having the lowest SOC to be lowest in a discharge state, so as to control the charge states of the battery cells 201a, 202a, and 203a connected in parallel to gradually become the same.

According to another comparative embodiment, unlike the comparative embodiment of FIG. 2, self-discharging may be performed using a self-discharge circuit connected in parallel to a battery cell having a high charge amount among battery cells connected in parallel, so as to control the charge states of battery cells to be the same.

In a case of a battery cell equivalent charging circuit employing a dynamic resistance scheme and/or a battery cell equivalent charging circuit employing a self-discharge circuit according to a comparative embodiment, a method of, when a more charged battery cell is detected, controlling to perform balancing work for the battery cell is used.

A battery cell equivalent charging circuit according to a comparative embodiment may have shortcomings as below. For example, in a case of a battery cell equivalent charging circuit employing a dynamic resistance scheme, while a path impedance for a battery cell to be balanced is maintained high, excessive current may be introduced and/or discharged to or from a battery cell which is not subject to be balanced. A battery cell exposed to relatively high current during balancing may undergo life deterioration. As another example, in a case of a battery cell equivalent charging circuit employing a self-discharge circuit, a part of the total charge amount of the entire battery is consumed in a self-discharge process, and thus a charge amount for the entire battery and an actual charge amount dischargeable from battery cells may not coincide with each other.

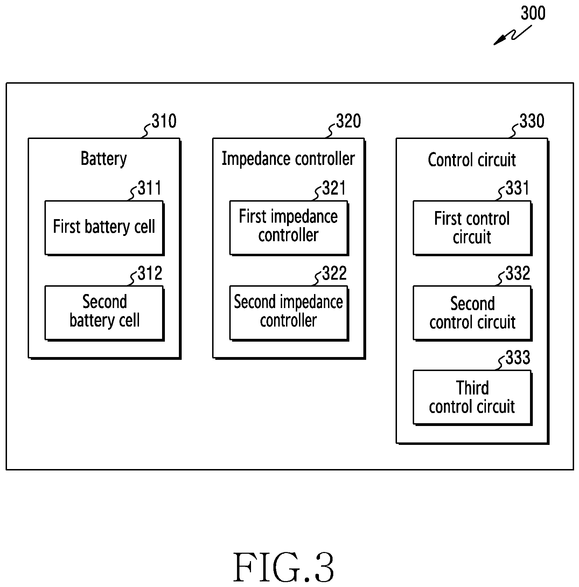

An embodiment of the disclosure provides a battery cell equivalent charging circuit (or a battery control system) and a battery cell equivalent control system (and a circuit enabling same) which adjusts, in real time, a ratio of distribution of, to battery cells, the entire current of a battery to obtain balancing effects, rather than providing battery cell equivalent control in terms of removing a charge amount difference at the time of occurrence of same. A battery control system according to an embodiment of the disclosure may control, in real time, a ratio by which the entire introduction/discharge current of a battery is distributed to battery cells connected in parallel and configure the battery such that the ratio converges into a particular value within a target range, and may minimize occurrence of a charge amount difference between the battery cells in real time. Hereinafter, a detailed description will be provided with reference to FIG. 3 to FIG. 9.

FIG. 3 is a block diagram illustrating a battery control system (e.g., the battery 189 in FIG. 1) according to an embodiment.

Referring to FIG. 3, a battery control system 300 according to an embodiment may include a battery 310, an impedance controller 320, and/or a control circuit 330. According to an embodiment, the battery control system 300 may include a first battery cell 311 and a second battery cell 312 connected in parallel, a first impedance controller 321 connected in series to the first battery cell 311, a second impedance controller 322 connected in series to the second battery cell 312, and the control circuit 330 which controls the first impedance controller 321 and the second impedance controller 322. The configuration of the battery control system 300 is not limited to the configuration shown in Figure 3, and may, for example, include an additional component(s). For example, the battery control system 300 may further include a third battery cell connected in parallel to the first battery cell 311 and the second battery cell 312, and a third impedance controller connected in series to the third battery cell.

According to an embodiment, the first battery cell 311 and the second battery cell 312 of the battery control system 300 may be charged and/or discharged by a flowing charge current and/or discharge current. A charge amount of each of the first battery cell 311 and the second battery cell 312 may be determined based on each rated capacity. A description based on a charging principle in the disclosure may also be applied to discharging.

According to an embodiment, the impedance controller 320 may be connected in series to the battery 310 to serve as a resistance valve (or a variable resistor) in the battery 310. For example, the first impedance controller 321 may control the magnitude of the impedance of a conductive path for the first battery cell 311, and may control the magnitude of a charge current (a discharge current) flowing in the first battery cell 311. For example, the second impedance controller 322 may control the magnitude of the impedance of a conductive path for the second battery cell 312, and may control the magnitude of a charge current (a discharge current) flowing in the second battery cell 312. The impedance controller 320 may perform the same role as that of a current controller.

According to an embodiment, for the impedance controller 320, various types of components capable of controlling the magnitude of the resistance applied to the battery 310 may be used. According to an embodiment, the impedance controller 320 may be a transistor and, for example, a field effect transistor (FET) may be used. A field effect transistor may generate an electric field, based on the magnitude of the voltage applied as a gate voltage, and adjust the magnitude of flowing current according to the strength of the electric field. For example, a field effect transistor may include a metal oxide semiconductor field effect transistor (MOSFET).

According to an embodiment, the control circuit 330 of the battery control system 300 may be electrically connected to the first battery cell 311, the second battery cell 312, the first impedance controller 321, and the second impedance controller 322. The control circuit 330 may control the first impedance controller 321 and the second impedance controller 322, based on the potential difference between the first battery cell 311 and the second battery cell 312, thereby controlling, to belong to (or be in) a predetermined range, a ratio of distribution of, into the first battery cell 311 and the second battery cell 312, the entire current flowing in the battery control system 300.

According to an embodiment, the control circuit 330 may be divided into a first control circuit 331, a second control circuit 332, and a third control circuit 333 according to a function performed thereby. For example, the first control circuit 331 may measure the potential difference between the first battery cell 311 and the second battery cell 312, and determine whether to control the impedance controller 320, based on a comparison between a value of the measured potential difference and a value of a target voltage range. For example, the second control circuit 332 may determine a target voltage range within which the potential difference between the first battery cell 311 and the second battery cell 312 is to be adjusted, and may determine a degree (e.g., the size of a signal to be applied to the impedance controller 320, or the magnitude of a gate voltage to be applied to the impedance controller 320) by which the impedance controller 320 is controlled. For example, the third control circuit 333 may measure the magnitude of the entire current flowing in the battery control system 300. The division between the first control circuit 331, the second control circuit 332, and the third control circuit 333 is for convenience of explanation, and these circuits may be actually implemented as one circuit in the battery control system 300.

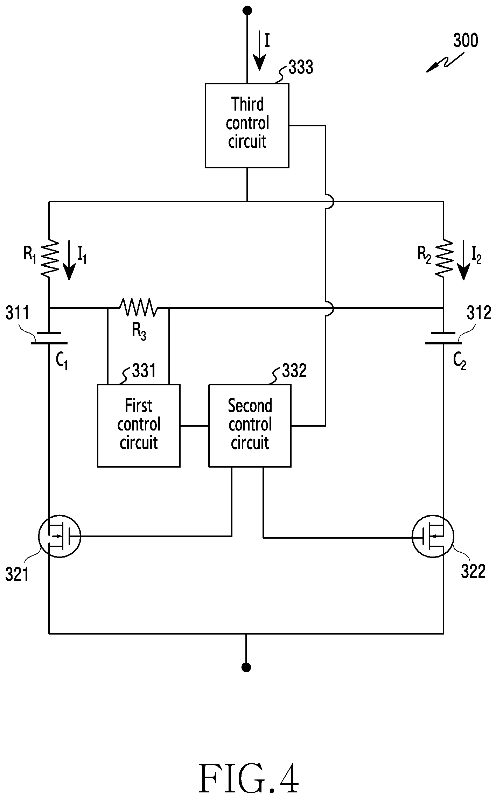

FIG. 4 is a diagram illustrating an example of the control circuit 330 of the battery control system 300 including the multiple battery cells 311 and 312 connected in parallel according to an embodiment.

FIG. 4 illustrates the control circuit 330 of the battery control system 300 including the first battery cell 311 and the second battery cell 312 connected to each other in parallel according to the disclosure.

In FIG. 4, the rated capacity of the first battery cell 311 is $C_1$, the rated capacity of the second battery cell 312 is $C_2$, the magnitude of the impedance of a conductive path for the first battery cell 311 is $R_1$, and the magnitude of the impedance of a conductive path for the second battery cell 312 is $R_2$. In addition, the magnitude of the current introduced into (discharged from) the battery control system 300 from an external charge circuit is I, the magnitude of the current distributed to the first battery cell 311 is Ii, and the magnitude of the current distributed to the second battery cell 312 is $I_2$

According to an embodiment, the first control circuit 331 may be disposed to be branched from a conductive path connected to the first battery cell 311, and from a conductive path connected to the second battery cell 312. The first control circuit 331 may measure the potential difference $\Delta V$ between the first battery cell 311 and the second battery cell 312, that is a difference in magnitude of a voltage drop caused by a branch current and a path impedance for the first battery cell 311 and the second battery cell 312. The potential difference $\Delta V$ between the first battery cell 311 and the second battery cell 312 may be defined by Equation 1 below.

[Equation 1]

$$\Delta V = \left| I_2 R_2 - I_1 R_1 \right|$$

According to an embodiment, the third control circuit 333 may be disposed at an introduction part before distribution of, to the first battery cell 311 and the second battery cell 312, the entire current of the battery control system 300. The third control circuit 333 may measure the magnitude of the entire current introduced/discharged into/from the battery control system 300.

According to an embodiment, the second control circuit 332 may be disposed to be electrically connected to the first control circuit 331, the third control circuit 333, the first impedance controller 321, and the second impedance controller 322. The second control circuit 332 may generate a signal for controlling the first impedance controller 321 and the second impedance controller 322, based on a signal (or data) received from the first control circuit 331 and the third control circuit 333.

According to an embodiment, the second control circuit 332 may determine a target value for adjusting a potential difference $\Delta V$ to control a ratio between the currents flowing in the first battery cell 311 and the second battery cell 312. For example, in a case in which a ratio between the magnitudes of the currents $I_1$ and $I_2$ introduced into the first battery cell 311 and the second battery cell 312 is controlled to always converge close to a specific ratio K within a predetermined range, the ratio between the magnitudes of $I_1$ and $I_2$ may be defined by Equation 2 below.

[Equation 2]

$$K(1 - k) \leq \frac{I_2}{I_1} \leq K(1 + k)$$

When a case of $I_2 R_2 \geq I_1 R_1$ in Equation 1 above is assumed, Equation 2 above may be transformed into Equation 3 below by using Equation 1.

[Equation 3]

$$I \frac{(R_2 K(1 - k) - R_1)}{1 + K(1 - k)} \leq \Delta V \leq I \frac{(R_2 K(1 + k) - R_1)}{1 + K(1 + k)}$$

According to an embodiment, the battery control system 300 may perform an operation of maintaining a potential difference $\Delta V$ measured by the second control circuit 332 within a range (hereinafter, referred to as a target voltage range) of Equation 3, thereby controlling the total introduced and/or discharged current I to be distributed to, at a particular ratio K, the first battery cell 311 and the second battery cell 312, which are unit battery cells included in the battery control system 300.

In order for the battery control system 300 to perform the above operation, the first control circuit 331 may include a logic circuit for determining whether the potential difference ΔV is included in the range of Equation 3. The logic circuit may generate a signal for controlling one of the first impedance controller 321 and the second impedance controller 322 according to whether the current potential difference ΔV is included in the range of Equation 3. The signal may be transferred to the second control circuit 332, and the second control circuit 332 may control a gate voltage applied to one of the first impedance controller 321 and the second impedance controller 322, based on the received signal. The second control circuit 332 according to an embodiment may perform a function of adjusting a ratio between an impedance magnitude for the first battery cell 311 and an impedance magnitude for the second battery cell 312 through control of the gate voltage applied to one of the first impedance controller 321 and the second impedance controller 322, thereby adjusting a ratio of the currents flowing in the first battery cell 311 and the second battery cell 312. When the ratio between the currents flowing in the first battery cell 311 and the second battery cell 312 is changed, this change may increase or decrease the magnitude of a potential difference ΔV measured (or monitored) by the first control circuit 331 again, and the magnitude of the potential difference ΔV may be adjusted to be included in a range of Equation 3.

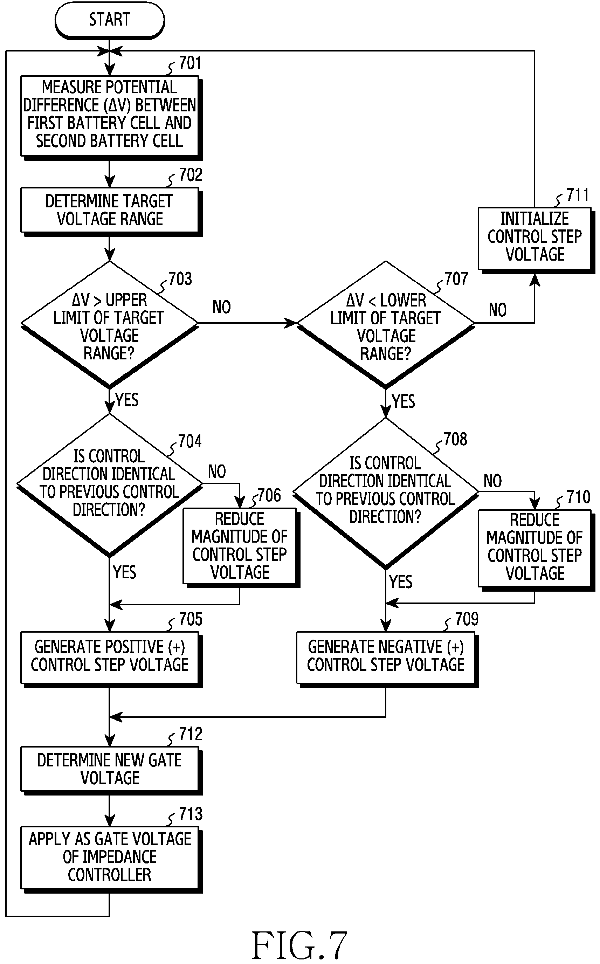

According to an embodiment, the second control circuit 332 may adjust the increase or decrease of the gate voltage applied to the impedance controller 320, based on a result of monitoring a potential difference by the first control circuit 331. For example, the increase or decrease of the gate voltage applied to the impedance controller 320 may be gradually reduced. A criterion of reducing the increase or decrease of the gate voltage will be described in detail below with reference to FIG. 7.

A potential difference ΔV may gradually converge within a range of Equation 3 through the increase or decrease of the gate voltage, and reduction of the increase or decrease described above. In equations defining an upper limit and a lower limit in Equation 3, all values except the entire current I are given as constants, and thus when the entire current I is measured, the range of the potential difference ΔV enabling a current ratio equivalent control operation for the battery 310 may be determined.

According to an embodiment, the battery control system 300 may control an operation of charging and discharging the first battery cell 311 and the second battery cell 312 connected in parallel at the level of the entire battery control system 300. For example, when $K = C_2/C_1$ is configured in Equation 2, a current corresponding to a 1C C-rate for the sum capacity $C_1+C_2$ may be applied as the entire current of the battery control system 300 so as to ensure the first battery cell 311 and the second battery cell 312 being both charged at a 1C C-rate.

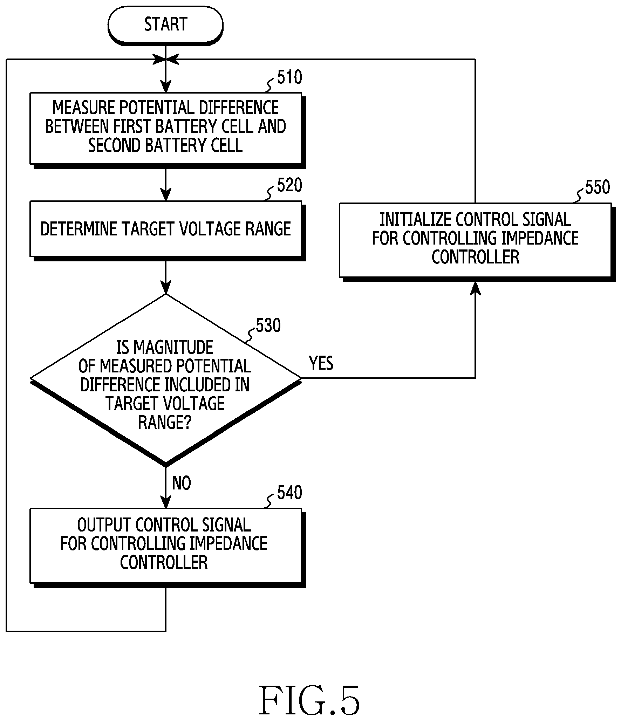

FIG. 5 is a flowchart illustrating a current ratio control method of the battery control system 300 according to an embodiment.

The battery control system 300 according to an embodiment may perform operation 510 of measuring a potential difference ΔV between the first battery cell 311 and the second battery cell 312, operation 520 of determining a target voltage range within which the potential difference is adjusted, operation 530 of determining whether a magnitude of the measured potential difference ΔV is included in the target voltage range, operation 540 of, based on the magnitude of the measured potential difference ΔV not being included in the target voltage range, outputting a control signal for controlling an impedance controller, and operation 550 of, based on the magnitude of the measured potential difference ΔV being included in the target voltage range, initializing the control signal for controlling the impedance controller 320.

According to an embodiment, the first control circuit 331 of the battery control system 300 may perform operation 510. The first control circuit 331 may measure the magnitude of a potential difference between the first battery cell 311 and the second battery cell 312.

According to an embodiment, the second control circuit 332 of the battery control system 300 may perform operation 520. The second control circuit 332 may determine an upper limit and a lower limit of a target voltage range, based on Equation 3, and transfer the determined values to the first control circuit 331.

According to an embodiment, the first control circuit 331 of the battery control system 300 may perform operation 530. The first control circuit 331 may determine whether the magnitude of the potential difference ΔV measured in operation 510 is included in the target voltage range determined in operation 520.

According to an embodiment, based on the first control circuit 331 determining that the magnitude of the potential difference ΔV is not included in the target voltage range in operation 530, the first control circuit may transfer a signal indicating same to the second control circuit 332, and the second control circuit 332 may perform operation 540. The second control circuit 332 may output a control signal for controlling the first impedance controller 321 or the second impedance controller 332, based on reception of the signal, and the magnitude of the gate voltage of the first impedance controller 321 or the magnitude of the gate voltage of the second impedance controller 332 may be adjusted based on the control signal.

According to an embodiment, based on the first control circuit 331 determining that the magnitude of the potential difference ΔV is included in the target voltage range in operation 530, a signal indicating same may be transferred to the second control circuit 332, and the second control circuit 332 may perform operation 550. The second control circuit 332 may initialize a control signal for controlling the first impedance controller 321 or the second impedance controller 332, based on reception of the signal, and the magnitude of the gate voltage of the first impedance controller 321 or the magnitude of the gate voltage of the second impedance controller 332 may be maintained without change, based on the initialized control signal.

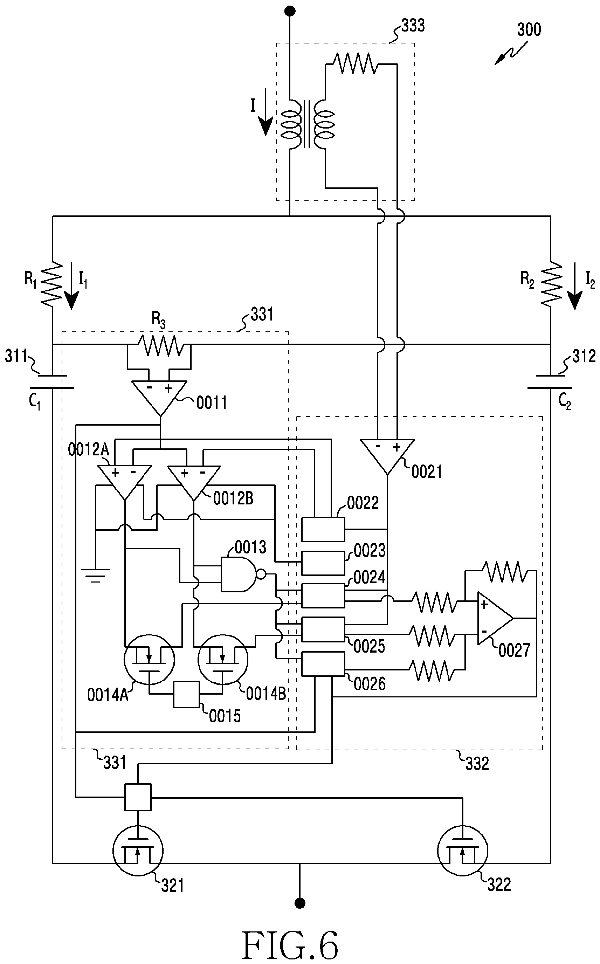

FIG. 6 is a diagram illustrating an example of the control circuit 330 of the battery control system 300 including the multiple battery cells 311 and 312 connected in parallel according to an embodiment.

The configuration of the control circuit 330 illustrated in FIG. 6 merely corresponds to an example of a circuit for implementing the operations of FIG. 4 and/or FIG. 5, and a circuit for performing a method for controlling a current ratio by the battery control system 300 according to the disclosure is not limited to the arrangement and components illustrated in FIG. 6.

Referring to FIG. 6, the first control circuit 331 may further include an additional logic circuit for generation of a signal due to a potential difference $\Delta V$ in addition to a supplementary resistor $R_3$ briefly illustrated in FIG. 6. According to an embodiment, the first control circuit 331 may include a voltage differential measurement unit (circuit) 0011, a first potential difference comparison determination unit (circuit) 0012A, a second potential difference comparison determination unit (circuit) 0012B, a reset signal generator 0013, a first comparison signal generation transistor 0014A, a second comparison signal generation transistor 0014B, and a clock generator 0015. According to an embodiment, the second control circuit 332 may include an entire current measurement unit (circuit) 0021, a target voltage range generator 0022, a logic circuit reference voltage generator 0023, an addition voltage generator 0024, a subtraction voltage generator 0025, a control reference voltage generator 0026, and a control voltage calculator 0027.

According to an embodiment, the voltage differential measurement unit 0011 may be disposed to be electrically connected to the supplementary resistor $R_3$ disposed to be branched from a conductive path of the first battery cell 311 and a conductive path of the second battery cell 312 so as to measure a value of a potential difference $\Delta V$ between the first battery cell 311 and the second battery cell 312. A signal indicating the potential difference $\Delta V$ may be transferred to the first potential difference comparison determination unit 0012A and the second potential difference comparison determination unit 0012B.

According to an embodiment, the target voltage range generator 0022 may be disposed to be electrically connected to the third control circuit 333. For example, the target voltage range generator 0022 may be disposed to be electrically connected to the entire current measurement unit 0021 which receives information of a value of the entire current I introduced and/or discharged into and/or from the battery control system 300, which is measured by the third control circuit 333. The target voltage range generator 0022 may determine a target voltage range by using Equation 3, and store the determined value. According to an embodiment, an upper limit and a lower limit of the target voltage range may be determined based on a value of the entire current I. A signal indicating the target voltage range may be transferred to the first potential difference comparison determination unit 0012A and the second potential difference comparison determination unit 0012B.

According to an embodiment, the first potential difference comparison determination unit 0012A and the second potential difference comparison determination unit 0012B may determine whether the magnitude of a potential difference measured by the voltage differential measurement unit 0011 is included in a target voltage range determined by the target voltage range generator 0022. According to an embodiment, the first potential difference comparison determination unit 0012A may be electrically connected to a ground and the logic circuit reference voltage generator 0023.

According to an embodiment, the logic circuit reference voltage generator 0023 may be a voltage generator which, based on a logic value required to be returned based on a comparison between the potential difference $\Delta V$ and the target voltage range by the first potential difference comparison determination unit 0012A and/or the second potential difference comparison determination unit 0012B being true, determines a reference voltage transferred from the first potential difference comparison determination unit 0012A to the first comparison signal generation transistor 0014A, and a reference voltage transferred from the second potential difference comparison determination unit 0012B to the second comparison signal generation transistor 0014B.

According to an embodiment, the first potential difference comparison determination unit 0012A may return a signal corresponding to a reference voltage magnitude (greater than 0) transferred from the logic circuit reference voltage generator 0023, based on the potential difference $\Delta V$ being greater than the upper limit of the target voltage range. For example, based on the potential difference $\Delta V$ being greater than the upper limit of the target voltage range, the first potential difference comparison determination unit 0012A may output a voltage corresponding to a reference voltage magnitude so as to enter the first comparison signal generation transistor 0014A into a conductive state.

According to an embodiment, the second potential difference comparison determination unit 0012B may return a signal corresponding to a reference voltage magnitude (greater than 0) transferred from the logic circuit reference voltage generator 0023, based on the potential difference $\Delta V$ being smaller than the lower limit of the target voltage range. For example, based on the potential difference $\Delta V$ being smaller than the lower limit of the target voltage range, the second potential difference comparison determination unit 0012B may output a voltage corresponding to a reference voltage magnitude so as to enter the second comparison signal generation transistor 0014B into a conductive state.

According to an embodiment, the first potential difference comparison determination unit 0012A and the second potential difference comparison determination unit 0012B may output a voltage of 0 V and transfer same to the reset signal generator 0013, based on the potential difference $\Delta V$ being equal to or smaller than the upper limit of the target voltage range and being equal to or greater than the lower limit (based on the potential difference $\Delta V$ being included in the target voltage range). The first comparison signal generation transistor 0014A and the second comparison signal generation transistor 0014B may not enter a conductive state.

According to an embodiment, the clock generator 0015 may periodically generate a square pulse to apply a gate voltage to the first comparison signal generation transistor 0014A and the second comparison signal generation transistor 0014B, thereby entering first comparison signal generation transistor 0014A and the second comparison signal generation transistor 0014B into a conductive state.

Based on the potential difference $\Delta V$ being greater than the upper limit of the target voltage range, the first comparison signal generation transistor 0014A having entered into a conductive state may apply a signal indicating deviation from the target voltage range to the addition voltage generator 0024. Based on the potential difference $\Delta V$ being smaller than the lower limit of the target voltage range, the second comparison signal generation transistor 0014B having entered into a conductive state may apply a signal indicating deviation from the target voltage range to the subtraction voltage generator 0025.

According to an embodiment, the addition voltage generator 0024 may generate a control step voltage for controlling the gate voltage of the first impedance controller 321 (e.g., a field effect transistor) or the gate voltage of the second impedance controller 322 (e.g., a field effect transistor) in response to reception of a signal indicating deviation from the target voltage range. According to an embodiment, the control step voltage generated by the addition voltage generator 0024 may have a positive (+) value.

According to an embodiment, the subtraction voltage generator 0025 may generate a control step voltage for controlling the gate voltage of the first impedance controller 321 (e.g., a field effect transistor) or the gate voltage of the second impedance controller 322 (e.g., a field effect transistor) in response to reception of a signal indicating deviation from the target voltage range. According to an embodiment, the control step voltage generated by the subtraction voltage generator 0025 may have a negative (-) value.

According to an embodiment, the control step voltage generated by the addition voltage generator 0024 and the subtraction voltage generator 0025 may be transferred to the control voltage calculator 0027.

According to an embodiment, the reset signal generator 0013 may initialize a signal for controlling the first impedance controller or a signal for controlling the second impedance controller in response to reception of a signal corresponding to a voltage of 0 volt from the first potential difference comparison determination unit 0012A and/or the second potential difference comparison determination unit 0012B. For example, the reset signal generator 0013 may initialize the magnitude of the control step voltage generated by the addition voltage generator 0024 and the subtraction voltage generator 0025.

According to an embodiment, the control reference voltage generator 0026 may store the magnitude of the current gate voltage being applied to the first impedance controller 321 and the magnitude of the current gate voltage being applied to the second impedance controller 322, and may transfer the values to the control voltage calculator 0027.

According to an embodiment, the control voltage calculator 0027 may determine a new gate voltage to be applied to the impedance controller 320, based on the current gate voltage of the impedance controller 320 received from the control reference voltage generator 0026 and the control step voltage received from the addition voltage generator 0024 and the subtraction voltage generator 0025. For example, the control voltage calculator 0027 may apply, as a new gate voltage of the first impedance controller 321 and the second impedance controller 322, a value obtained by adding or subtracting the magnitude of the control step voltage to or from the current gate voltage.

According to an embodiment, the control voltage calculator 0027 may determine one to be controlled (e.g., to which a new gate voltage is to be applied) among the first impedance controller 321 and the second impedance controller 322, based on the direction of the current flowing in $R_3$. According to an embodiment, the control voltage calculator 0027 may determine one to be controlled among the first impedance controller 321 and the second impedance controller 322, based on a magnitude comparison between the voltage applied to the first battery cell 311 (the multiplication between the current $I_1$ flowing in the first battery cell 311 and the impedance $R_1$ of a conductive path of the first battery cell 311) and the voltage applied to the second battery cell 312 (the multiplication between the current $I_2$ flowing in the second battery cell 312 and the impedance $R_2$ of a conductive path of the second battery cell 312). For example, based on the direction of the current flowing in $R_3$ being to the left in FIG. 6 (based on the voltage applied to the second battery cell 312 being greater than the voltage applied to the first battery cell 311), the control voltage calculator 0027 may determine the first impedance controller 321 to be controlled among the first impedance controller 321 and the second impedance controller 322, and apply a new gate voltage to the first impedance controller 321. For example, based on the direction of the current flowing in $R_3$ being to the right in FIG. 6 (based on the voltage applied to the first battery cell 311 being greater than the voltage applied to the second battery cell 312), the control voltage calculator 0027 may determine the second impedance controller 322 to be controlled among the first impedance controller 322 and the second impedance controller 322, and apply a new gate voltage to the second impedance controller 322.

According to an embodiment, the impedance controller 320 to be controlled may be in an active state, and the gate voltage thereof may be updated to a new value generated by the control voltage generator 0027. According to an embodiment, the updated gate voltage value may be stored in the control reference voltage generator 0026 again.

According to an embodiment, based on the addition voltage generator 0024 and the subtraction voltage generator 0025 consecutively alternately receiving a positive (+) target voltage range deviation signal (i.e., a signal indicating the potential difference $\Delta V$ being greater than the upper limit of the target voltage range) and a negative (-) target voltage range deviation signal (i.e., a signal indicating the potential difference $\Delta V$ being smaller than the lower limit of the target voltage range) within a predetermined time, the addition voltage generator 0024 and the subtraction voltage generator 0025 may reduce the magnitude of a control step voltage generated thereby. For example, the addition voltage generator 0024 and the subtraction voltage generator 0025 may halve the magnitude of a control step voltage generated thereby so as to accomplish more precise control.

According to an embodiment, the third control circuit 333 may measure the magnitude of the entire current I introduced and/or discharged to and/or from the battery control system 300, and transfer the measured value to the target voltage range generator 0022 via the entire current measurement unit 0021. The target voltage range generator 0022 of the second control circuit 332 may adjust the range of $\Delta V$ to be proportional to the magnitude of the I value measured by the third control circuit 333, based on Equation 3. Accordingly, the battery control system 300 may perform, for a random magnitude of the entire current I, an operation of consistently maintaining a ratio of distribution of a charge current and/or discharge current.

FIG. 7 is a flowchart illustrating a current ratio control method of the battery control system 300 according to an embodiment.

According to an embodiment, operation 701 in FIG. 7 may correspond to operation 510 in FIG. 5; operation 702 in FIG. 7 may correspond to operation 520 in FIG. 5; operation 703 and operation 707 in FIG. 7 may correspond to operation 530 in FIG. 5; operation 704 to operation 706, operation 708 to operation 710, operation 712, and operation 713 in FIG. 7 may correspond to operation 540 in FIG. 5; and operation 711 in FIG. 7 may correspond to operation 550 in FIG. 5. Hereinafter, an overlapped description for an operation will not be repeated.

According to an embodiment, the voltage differential measurement unit 0011 of the battery control system 300 may perform operation 701. The voltage differential measurement unit 0011 may measure the magnitude of a potential difference $\Delta V$ between the first battery cell 311 and the second battery cell 312.

According to an embodiment, the target voltage range generator 0022 of the battery control system 300 may perform operation 702. The target voltage range generator 0022 may determine an upper limit and a lower limit of a target voltage range, based on Equation 3, and transfer the determined values to the first potential difference comparison determination unit 0012A and the second potential difference comparison determination unit 0012B.

According to an embodiment, the first potential difference comparison determination unit 0012A of the battery control system 300 may perform operation 703. The first potential difference comparison determination unit 0012A may determine whether the magnitude of the potential difference $\Delta V$ measured in operation 701 is greater than the upper limit of the target voltage range determined in operation 702.

According to an embodiment, based on the first potential difference comparison determination unit 0012A determining that the magnitude of the potential difference $\Delta V$ is greater than the upper limit of the target voltage range, the first comparison signal generation transistor 0014A having been converted into a conductive state by the clock generator 0015 may transfer a signal indicating the magnitude of the potential difference $\Delta V$ being greater than the upper limit of the target voltage range to the addition voltage generator 0024.

According to an embodiment, based on the first potential difference comparison determination unit 0012A determining that the magnitude of the potential difference $\Delta V$ is greater than the upper limit of the target voltage range, the addition voltage generator 0024 of the battery control system 300 may perform operation 704. The addition voltage generator 0024 may determine whether the current control direction of the impedance controller 320 is identical to a previous control direction. For example, the addition voltage generator 0024 may determine whether a current control corresponds to increasing the gate voltage of the impedance controller 320 within a predetermined time after previous reduction of the gate voltage of the impedance controller 320. For example, the addition voltage generator 0024 may determine whether a case in which the magnitude of a potential difference is smaller than the lower limit of the target voltage range and a case in which the magnitude of the potential difference is greater than the upper limit of the target voltage range have been alternately detected within a predetermined time.

Based on determining the current control direction of the impedance controller 320 to be identical to a previous control direction, the addition voltage generator 0024 may perform operation 705. The addition voltage generator 0024 may generate a positive (+) control step voltage in response to a signal indicating that the magnitude of the potential difference $\Delta V$ is greater than the upper limit of the target voltage range. The magnitude of the generated control step voltage may be the same as that of a control step voltage generated immediately before.

Based on determining the current control direction of the impedance controller 320 not to be identical to a previous control direction (based on a case in which the magnitude of a potential difference is smaller than the lower limit of the target voltage range and a case in which the magnitude of the potential difference is greater than the upper limit of the target voltage range have been alternately detected within a predetermined time), the addition voltage generator 0024 may perform operation 706. The addition voltage generator 0024 may generate a positive (+) control step voltage having a reduced magnitude compared to a previous magnitude in response to a signal indicating that the magnitude of the potential difference $\Delta V$ is greater than the upper limit of the target voltage range. For example, the magnitude of the generated control step voltage may be half of that of a control step voltage generated immediately before. According to an embodiment, the addition voltage generator 0024 may generate a positive (+) control step voltage having a reduced magnitude compared to a previous magnitude in the case that a positive (+) target voltage range deviation signal is consecutively alternately received within a predetermined time after reception of a negative (-) target voltage range deviation signal. A value of a reduced ratio is not limited to the above description.

According to an embodiment, based on the first potential difference comparison determination unit 0012A determining that the magnitude of the potential difference $\Delta V$ is smaller than the upper limit of the target voltage range, the second potential difference comparison determination unit 0012B of the battery control system 300 may perform operation 707. The second potential difference comparison determination unit 0012B may determine whether the magnitude of the potential difference $\Delta V$ measured in operation 701 is smaller than the lower limit of the target voltage range determined in operation 702.

According to an embodiment, based on the second potential difference comparison determination unit 0012B determining that the magnitude of the potential difference $\Delta V$ is smaller than the lower limit of the target voltage range, the second comparison signal generation transistor 0014B having been converted into a conductive state by the clock generator 0015 may transfer a signal indicating the magnitude of the potential difference $\Delta V$ being smaller than the lower limit of the target voltage range to the subtraction voltage generator 0025.

According to an embodiment, based on the second potential difference comparison determination unit 0012B determining that the magnitude of the potential difference $\Delta V$ is smaller than the lower limit of the target voltage range, the subtraction voltage generator 0025 of the battery control system 300 may perform operation 708. The subtraction voltage generator 0028 may determine whether the current control direction of the impedance controller 320 is identical to a previous control direction. For example, the subtraction voltage generator 0025 may determine whether a current control corresponds to a case of reducing the gate voltage of the impedance controller 320 within a predetermined time after previously increasing the gate voltage of the impedance controller 320. For example, the subtraction voltage generator 0025 may determine whether a case in which the magnitude of a potential difference is greater than the upper limit of the target voltage range and a case in which the magnitude of the potential difference is smaller than the lower limit of the target voltage range have been alternately detected within a predetermined time.

Based on the current control direction of the impedance controller 320 being determined to be identical to a previous control direction, the subtraction voltage generator 0025 may perform operation 709. The subtraction voltage generator 0025 may generate a negative (-) control step voltage in response to a signal indicating that the magnitude of the potential difference $\Delta V$ is smaller than the lower limit of the target voltage range. The magnitude of the generated control step voltage may be the same as that of a control step voltage generated immediately before.

Based on the current control direction of the impedance controller 320 being determined not to be identical to a previous control direction (based on a case in which the magnitude of a potential difference is greater than the upper limit of the target voltage range and a case in which the magnitude of the potential difference is smaller than the lower limit of the target voltage range have been alternately detected within a predetermined time), the subtraction voltage generator 0025 may perform operation 710. The subtraction voltage generator 0025 may generate a negative (-) control step voltage having a reduced magnitude compared to a previous magnitude in response to a signal indicating that the magnitude of the potential difference $\Delta V$ is smaller than the lower limit of the target voltage range. For example, the magnitude of the generated control step voltage may be half of that of a control step voltage generated immediately before. According to an embodiment, the subtraction voltage generator 0025 may generate a negative (-) control step voltage having a reduced magnitude compared to a previous magnitude in a case that a negative (-) target voltage range deviation signal is consecutively alternately received within a predetermined time after reception of a positive (+) target voltage range deviation signal. A value of a reduced ratio is not limited to the above description.

According to an embodiment, based on the first potential difference comparison determination unit 0012A determining that the magnitude of the potential difference $\Delta V$ is smaller than the upper limit of the target voltage range, and the second potential difference comparison determination unit 0012B determining that the magnitude of the potential difference $\Delta V$ is greater than the lower limit of the target voltage range, the reset signal generator 0013 of the battery control system 300 may perform operation 711. The reset signal generator 0013 may initialize a signal for controlling the impedance controller 320 in response to reception of a signal indicating the magnitude of the potential difference $\Delta V$ is included in the target voltage range. For example, the reset signal generator 0013 may initialize a control step voltage generated by the addition voltage generator 0024 and the subtraction voltage generator 0025 in response to reception of a signal indicating the magnitude of the potential difference $\Delta V$ is included in the target voltage range.

Accordingly, the magnitude of the gate voltage of the first impedance controller 321 and/or the magnitude of the gate voltage of the second impedance controller 322 may be maintained without change.

According to an embodiment, the control voltage calculator 0027 of the battery control system 300 may perform operation 712 and operation 713. The control voltage calculator 0027 may apply, as a new gate voltage of the impedance controller 320, a value obtained by adding the control step voltage received from the addition voltage generator 0024 to the current gate voltage of the impedance controller 320 received from the control reference voltage generator 0026, or a value obtained by subtracting the control step voltage received from the subtraction voltage generator 0025 from the same current gate voltage. The control voltage calculator 0027 may determine one to be controlled among the first impedance controller 321 and the second impedance controller 322, to which a new gate voltage is to be applied. For example, based on the direction of the current flowing in $R_3$ being to the left in FIG. 6 (based on the voltage applied to the second battery cell 312 being greater than the voltage applied to the first battery cell 311), the control voltage calculator 0027 may determine the first impedance controller 321 to be controlled among the first impedance controller 321 and the second impedance controller 322, and apply a new gate voltage to the first impedance controller 321. For example, based on the direction of the current flowing in $R_3$ being to the right in FIG. 6 (based on the voltage applied to the first battery cell 311 being greater than the voltage applied to the second battery cell 312), the control voltage calculator 0027 may determine the second impedance controller 322 to be controlled among the first impedance controller 322 and the second impedance controller 322, and apply a new gate voltage to the second impedance controller 322.

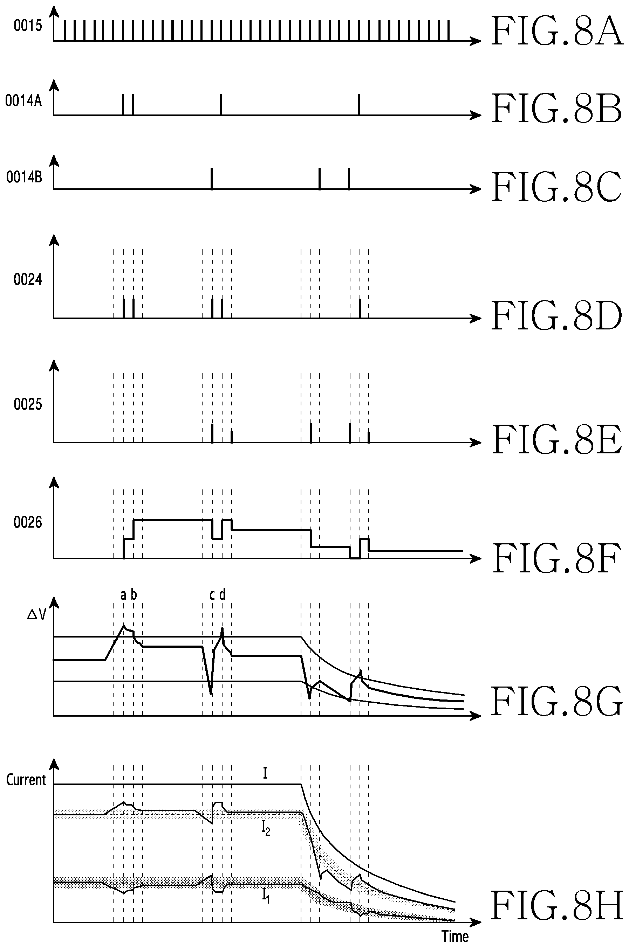

FIGS. 8A, 8B, 8C, 8D, 8E, 8F, 8G, and 8H are graphs illustrating a process of controlling a current ratio within a predetermined range in the battery control system 300 according to an embodiment.

With reference to FIG. 8, a case in which it is assumed that the rated capacity $C_1$ of the first battery cell 311 is twice the rated capacity $C_2$ of the second battery cell 312 ($C_1 = 2C_2$), a current ratio control target is 2 (K=2), a current ratio error limit is 2% (k=0.02), and $I_2R_2$ is greater than $I_1R_1$ ($I_2R_2 > I_1R_1$) will be described.

While the entire charge current I of the battery control system 300 is maintained at a predetermined magnitude, a ratio between the charge current $I_1$ of the first battery cell 311 and the charge current $I_2$ of the second battery cell 312 may be maintained at a configured control target ($I_2/I_1 = 2$), or may be changed due to various causes. Whether the current ratio ($I_2/I_1$) is within a target control range (i.e., whether $K - k < I_2/I_1 < K + k$ is satisfied) may be measured by the voltage differential measurement unit 0011 with reference to Equation 3 described above.

FIG. 8A shows signals generated (output) by the clock generator 0015 over time in a process of controlling the current ratio ($I_2/I_1$) to be included in a predetermined range. FIG. 8B shows signals generated (output) by the first comparison signal generation transistor 0014A over time in a process of controlling the current ratio ($I_2/I_1$) to be included in a predetermined range. FIG. 8C shows signals generated (output) by the second comparison signal generation transistor 0014B over time in a process of controlling the current ratio ($I_2/I_1$) to be included in a predetermined range. FIG. 8D shows signals for a control step voltage generated (output) by the addition voltage generator 0024 over time in a process of controlling the current ratio ($I_2/I_1$) to be included in a predetermined range. FIG. 8E shows signals for a control step voltage generated (output) by the subtraction voltage generator 0025 over time in a process of controlling the current ratio ($I_2/I_1$) to be included in a predetermined range. FIG. 8F shows a signal for a current gate voltage stored in the control reference voltage generator 0026 over time in a process of controlling the current ratio ($I_2/I_1$) to be included in a predetermined range. FIG. 8G shows signals for a potential difference $\Delta V$ measured by the voltage differential measurement unit 0011 over time in a process of controlling the current ratio ($I_2/I_1$) to be included in a predetermined range. FIG. 8H shows changes in magnitude of the entire charge current I, the charge current $I_1$ of the first battery cell 311, and the charge current $I_2$ of the second battery cell 312 over time in a process of controlling the current ratio ($I_2/I_1$) to be included in a predetermined range.

Shadow areas in FIG. 8H indicate the ranges of $I_1$ and $I_2$ satisfying Equation 2 above.

The charge current ratio ($I_2/I_1$) is noted to be maintained within a target range until time point a, but to deviate from the target range at time point a. At time point a, the magnitude of the potential difference $\Delta V$ measured by the voltage differential measurement unit 0011 becomes greater than the upper limit of the target voltage range generated by the target voltage range generator 0022, and the first comparison signal generation transistor 0014A enters into a conductive state so that a pulse generated by the clock generator 0015 may be transferred to the addition voltage generator 0024. The addition voltage generator 0024 may generate a positive (+) control step voltage and transfer same to the control voltage calculator 0027. The control voltage calculator 0027 may apply, as a new gate voltage to the first impedance controller 321, a value obtained by adding the control step voltage to the current gate voltage being applied to the first impedance controller 321.

Even with the application of an added new gate voltage at time point a, the charge current ratio does not converge within the target range even up to time point b, and the potential difference $\Delta V$ measured by the voltage differential measurement unit 0011 is still beyond the upper limit of the target voltage range. Accordingly, the above process may be performed one more time. A pulse may be transferred from the first comparison signal generation transistor 0014A to the addition voltage generator 0024 one more time, and the addition voltage generator 0024 may generate a positive (+) control step voltage and transfer same to the control voltage calculator 0027. The control voltage calculator 0027 may apply an added new gate voltage to the first impedance controller 321 one more time.

It is noted that, through the two gate voltage addition operations, after time point b, the potential difference $\Delta V$ is reduced to the level of the target voltage range, and the charge current ratio is also maintained at a target level.

At time point c, the charge current of the second battery cell 312 is reduced and the charge current of the first battery cell 311 is increased, and thus the magnitude of the potential difference $\Delta V$ measured by the voltage differential measurement unit 0011 becomes smaller than the lower limit of the target voltage range generated by the target voltage range generator 0022. The second comparison signal generation transistor 0014B enters into a conductive state, and a pulse generated by the clock generator 0015 may be transferred to the subtraction voltage generator 0025. The subtraction voltage generator 0025 may generate a negative (-) control step voltage and transfer same to the control voltage calculator 0027. The control voltage calculator 0027 may apply, as a new gate voltage to the first impedance controller 321, a value obtained by subtracting the control step voltage from the current gate voltage being applied to the first impedance controller 321.

Accordingly, the charge current of the second battery cell 312 is increased and the charge current of the first battery cell 311 is reduced. However, even with the application of a new subtracted gate voltage, the charge current ratio is still not stable to be within the target range, and the potential difference $\Delta V$ at time point d is higher than the upper limit of the target voltage range. This implies a state in which it may be impossible to precisely adjust the gate voltage of the first impedance controller 321, based on the magnitude of the current control step voltage. The addition voltage generator 0024 may reduce the magnitude of the control step voltage generated thereby so as to accomplish more precise control. For example, the addition voltage generator 0024 may generate a positive (+) control step voltage that is half of that at time point a (or time point b), and transfer same to the control voltage calculator 0027. The control voltage calculator 0027 may apply an added new gate voltage to the first impedance controller 321, so that the charge current ratio ($I_2/I_1$) may be controlled to be maintained within the target range.

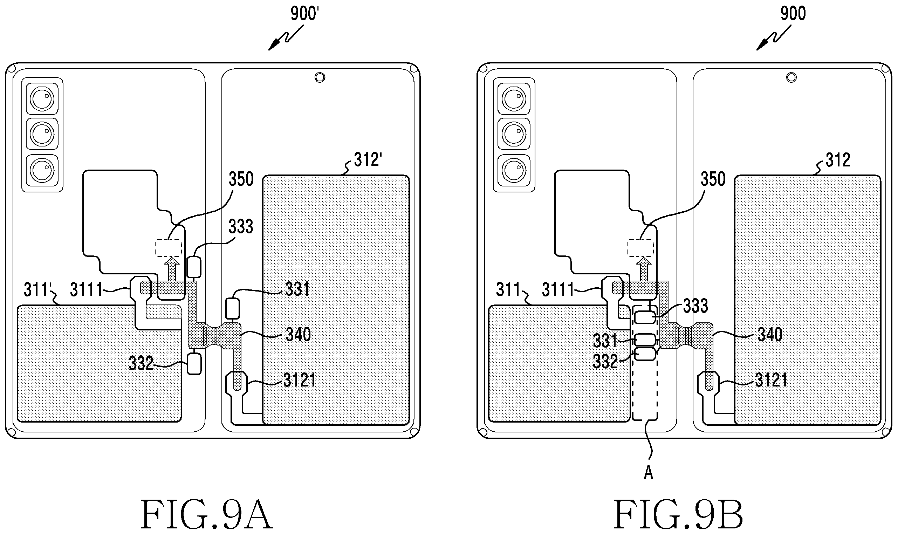

FIGS. 9A and 9B illustrate an example of a battery control system disposed in a foldable electronic device (e.g., the electronic device 101 in FIG. 1) according to an embodiment.

FIGS. 9A and 9B illsutrate an example of one configuration for applying a current ratio equivalent control method of the disclosure to a foldable electronic device.

A foldable electronic device is required to implement, in a limited space, a high-capacity battery capable of responding to high power consumption occurring due to an increased front display size compared to a general bar-type electronic device. For example, a battery including heterogeneous battery cells having different rated capacities connected in parallel may be applied to a foldable electronic device.

FIG. 9A is an example in which a battery control system including heterogeneous battery packs 311' and 312' connected in parallel is applied to a foldable electronic device 900', and FIG. 9B is an example in which a battery control system including heterogeneous battery cells 311 and 312 connected in parallel is applied to a foldable electronic device 900.

Referring to FIG. 9A, the first battery pack 311' and the second battery pack 312'may configure a parallelly connected battery structure by means of printed circuit boards (not illustrated) each including a battery protection circuit for controlling an individual battery pack, connectors 3111 and 3121 extending out from the printed circuit boards and being connected to a battery connector 340, and the battery connector 340 being connected to a power management IC (PMIC) 350. According to an embodiment, the first control circuit 331, the second control circuit 332, and the third control circuit 333 may be arranged in a separate embedding area of the foldable electronic device 900'. For example, the battery control system of the disclosure may be implemented in the foldable electronic device 900' by a method in which a circuit equivalent to the embodiment of FIG. 4 or the embodiment of FIG. 6 is printed on the connectors 3111, 3121, and 340.

Referring to FIG. 9B, the first battery cell 311 and the second battery cell 312 may be a type of not additionally including a printed circuit board for embedding an individual protection circuit. The first battery cell 311 and the second battery cell 312 may configure a parallelly connected battery structure by means of connectors 3111 and 3121 extending out from the individual battery cells and being connected to a battery connector 340, and the battery connector 340 being connected to a power management IC (PMIC) 350. The same total rated capacity may be maintained without protection circuits, and thus the foldable electronic device 900 may have an additional empty space A (i.e., an embedding space required for a protection circuit) compared to FIG. 9A. The first control circuit 331, the second control circuit 332, and the third control circuit 333 of the disclosure may be easily embedded using the entirety or a part of the empty space A.

As described above, a battery control system (e.g., the battery 189 in FIG. 1 or the battery control system 300 in FIG. 3) according to an embodiment may include a first battery cell (e.g., the first battery cell 311 in FIG. 3), a second battery cell (e.g., the second battery cell 312 in FIG. 3) connected in parallel to the first battery cell, a first impedance controller (e.g., the first impedance controller 321 in FIG. 3) connected in series to the first battery cell, a second impedance controller (e.g., the second impedance controller 322 in FIG. 3) connected in series to the second battery cell, and a control circuit (e.g., the control circuit 330 in FIG. 3) electrically connected to the first battery cell, the second battery cell, the first impedance controller, and the second impedance controller, wherein the control circuit may be configured to: measure a potential difference between the first battery cell and the second battery cell; determine whether a magnitude of the potential difference is included in a first range; and, based on determining that the magnitude of the potential difference is not included in the first range, control one of the first impedance controller and the second impedance controller, so as to control a ratio by which the entire current introduced into the battery control system is distributed to the first battery cell and the second battery cell, to be included in a predetermined range.

According to an embodiment, the control circuit may be configured to, based on determining that the magnitude of the potential difference is included in the first range, initialize a signal for controlling the first impedance controller or a signal for controlling the second impedance controller.

According to an embodiment, the first impedance controller may be a first transistor, the second impedance controller may be a second transistor, and the control circuit may be configured to, based on determining that the magnitude of the potential difference is not included in the first range, control a magnitude of a first gate voltage of the first transistor or a magnitude of a second gate voltage of the second transistor.

According to an embodiment, the control circuit may be configured to, based on determining that the magnitude of the potential difference is not included in the first range, determine a control step voltage for controlling the first gate voltage or the second gate voltage, and, based on the magnitude of the potential difference being greater than an upper limit of the first range, apply, as a new first gate voltage, a value obtained by adding the control step voltage to a current first gate voltage, or apply, as a new second gate voltage, a value obtained by adding the control step voltage to a current second gate voltage.

According to an embodiment, the control circuit may be configured to, based on the magnitude of the potential difference being smaller than a lower limit of the first range, apply, as the new first gate voltage, a value obtained by subtracting the control step voltage from the current first gate voltage, or apply, as the new second gate voltage, a value obtained by subtracting the control step voltage from the current second gate voltage.

According to an embodiment, the control circuit may be configured to, in response to alternate detection of, within a predetermined time, a case in which the magnitude of the potential difference is greater than the upper limit of the first range and a case in which the magnitude of the potential difference is smaller than the lower limit of the first range, reduce a magnitude of the control step voltage.

According to an embodiment, the control circuit may be configured to, based on determining that the magnitude of the potential difference is not included in the first range, determine one to be controlled among the first impedance controller and the second impedance controller, based on a magnitude comparison between a first voltage applied to the first battery cell and a first voltage applied to the second battery cell, and the first voltage may be obtained by multiplying a current flowing in the first battery cell by an impedance of a conductive path of the first battery cell, and the second voltage may be obtained by multiplying a current flowing in the second battery cell by an impedance of a conductive path of the second battery cell.

According to an embodiment, an upper limit and a lower limit of the first range may be proportional to a magnitude of the entire current introduced into the battery control system.

As described above, a battery control method according to an embodiment may include measuring a potential difference between a first battery cell and a second battery cell connected in parallel to the first battery cell (e.g., operation 510 in FIG. 5), determining whether a magnitude of the potential difference is included in a first range (e.g., operation 530 in FIG. 5) and, based on determining that the magnitude of the potential difference is not included in the first range, controlling one of a first impedance controller connected in series to the first battery cell and a second impedance controller connected in series to the second battery cell, so as to control a ratio by which an entire current introduced into the battery control system is distributed to the first battery cell and the second battery cell, to be included in a predetermined range (e.g., operation 540 in FIG. 5).

According to an embodiment, the battery control method may further include, based on determining that the magnitude of the potential difference is included in the first range, initializing a signal for controlling the first impedance controller or a signal for controlling the second impedance controller.

According to an embodiment, the first impedance controller may be a first transistor, the second impedance controller may be a second transistor, and the controlling of the ratio of distribution of the entire current to be included in the predetermined range may include, based on determining that the magnitude of the potential difference is not included in the first range, controlling a magnitude of a first gate voltage of the first transistor or a magnitude of a second gate voltage of the second transistor.

According to an embodiment, the controlling of the ratio of distribution of the entire current to be included in the predetermined range may include, based on determining that the magnitude of the potential difference is not included in the first range, determining a control step voltage for controlling the first gate voltage or the second gate voltage, based on the magnitude of the potential difference being greater than an upper limit of the first range, applying, as a new first gate voltage, a value obtained by adding the control step voltage to a current first gate voltage, or applying, as a new second gate voltage, a value obtained by adding the control step voltage to a current second gate voltage, and, based on the magnitude of the potential difference being smaller than a lower limit of the first range, applying, as the new first gate voltage, a value obtained by subtracting the control step voltage from the current first gate voltage, or applying, as the new second gate voltage, a value obtained by subtracting the control step voltage from the current second gate voltage.

According to an embodiment, the determining of the control step voltage may include, in response to alternate detection of, within a predetermined time, a case in which the magnitude of the potential difference is greater than the upper limit of the first range and a case in which the magnitude of the potential difference is smaller than a lower limit of the first range, reducing a magnitude of the control step voltage.

According to an embodiment, the controlling of the ratio of distribution of the entire current to belong to the predetermined range may include, based on determining that the magnitude of the potential difference is not included in the first range, determining one to be controlled among the first impedance controller and the second impedance controller, based on a magnitude comparison between a first voltage applied to the first battery cell and a first voltage applied to the second battery cell, and the first voltage may be obtained by multiplying a current flowing in the first battery cell by an impedance of a conductive path of the first battery cell, and the second voltage may be obtained by multiplying a current flowing in the second battery cell by an impedance of a conductive path of the second battery cell.

According to an embodiment, an upper limit and a lower limit of the first range may be proportional to a magnitude of the entire current introduced into the battery control system.

As described above, an electronic device (e.g., the electronic device 101 in FIG. 1 or the foldable electronic device 900 or 900' in FIG. 9) according to an embodiment may include a housing, a first battery cell (e.g., the first battery cell 311 in FIG. 3) disposed in the housing, a second battery cell (e.g., the second battery cell 312 in FIG. 3) disposed in the housing and connected in parallel to the first battery cell, and a control circuit (e.g., the control circuit 330 in FIG. 3) electrically connected to the first battery cell and the second battery cell, wherein the control circuit may be configured to: measure a first potential difference between the first battery cell and the second battery cell; determine a target voltage range within which the potential difference between the first battery cell and the second battery cell is to be adjusted; determine whether a magnitude of the measured first potential difference is included in the target voltage range; and, based on determining that the magnitude of the first potential difference is not included in the target voltage range, adjust the magnitude of the first potential difference to be included the target voltage range, thereby controlling a ratio by which an entire current introduced into the battery control system is distributed to the first battery cell and the second battery cell, to belong to a predetermined range.

According to an embodiment, the electronic device may further include a first transistor connected in series to the first battery cell, and a second transistor connected in series to the second battery cell, wherein the control circuit may be configured to, based on determining that the magnitude of the first potential difference is not included in the target voltage range, control a first gate voltage of the first transistor and a second gate voltage of the second transistor through a signal for controlling the first gate voltage or a signal for controlling the second gate voltage, thereby controlling a ratio by which an entire current introduced into the battery control system is distributed to the first battery cell and the second battery cell, to be included in a predetermined range.

According to an embodiment, the control circuit may be configured to, based on determining that the magnitude of the first potential difference is included in the target voltage range, initialize a signal for controlling the first gate voltage of the first transistor or a signal for controlling the second gate voltage of the second transistor.

According to an embodiment, the control circuit may be configured to, in response to alternate detection of, within a predetermined time, a case in which the magnitude of the first potential difference is greater than the upper limit of the target voltage range and a case in which the magnitude of the first potential difference is smaller than the lower limit of the target voltage range, reduce a control range of the first gate voltage or a control range of the second gate voltage.

According to an embodiment, an upper limit and a lower limit of the target voltage range may be proportional to a magnitude of the entire current introduced into the first battery cell and the second battery cell.

**Claims**

**1.** A battery control system comprising:

a first battery cell;
a second battery cell connected in parallel to the first battery cell;
a first impedance controller connected in series to the first battery cell;
a second impedance controller connected in series to the second battery cell; and
a control circuit electrically connected to the first battery cell, the second battery cell, the first impedance controller, and the second impedance controller, wherein the control circuit is configured to:

measure a potential difference between the first battery cell and the second battery cell;

determine whether a magnitude of the potential difference is included in a first range; and
based on determining that the magnitude of the potential difference is not included in the first range, control one of the first impedance controller and the second impedance controller, so as to control a ratio by which the entire current introduced into the battery control system is distributed to the first battery cell and the second battery cell, to be included in a predetermined range.

2.  The battery control system of claim 1, wherein the control circuit is configured to:
    based on determining that the magnitude of the potential difference is included in the first range, initialize a signal for controlling the first impedance controller or a signal for controlling the second impedance controller.

3.  The battery control system of claim 1, wherein the first impedance controller comprises a first transistor,

    the second impedance controller comprises a second transistor, and
    the control circuit is configured to:
    based on determining that the magnitude of the potential difference is not included in the first range, control a magnitude of a first gate voltage of the first transistor or a magnitude of a second gate voltage of the second transistor.

4.  The battery control system of claim 3, wherein the control circuit is configured to:

    based on determining that the magnitude of the potential difference is not included in the first range, determine a control step voltage for controlling the first gate voltage or the second gate voltage, and
    based on the magnitude of the potential difference being greater than an upper limit of the first range, apply, as a new first gate voltage, a value obtained by adding the control step voltage to a current first gate voltage, or apply, as a new second gate voltage, a value obtained by adding the control step voltage to a current second gate voltage.

5.  The battery control system of claim 4, wherein the control circuit is configured to:
    based on the magnitude of the potential difference being smaller than a lower limit of the first range, apply, as the new first gate voltage, a value obtained by subtracting the control step voltage from the current first gate voltage, or apply, as the new second gate voltage, a value obtained by subtracting the control step voltage from the current second gate voltage.

6.  The battery control system of claim 5, wherein the control circuit is configured to:
    in response to alternate detection of, within a predetermined time, a case in which the magnitude of the potential difference is greater than the upper limit of the first range and a case in which the magnitude of the potential difference is smaller than the lower limit of the first range, reduce a magnitude of the control step voltage.

7.  The battery control system of claim 1, wherein the control circuit is configured to:

    based on determining that the magnitude of the potential difference is not included in the first range, determine one to be controlled among the first impedance controller and the second impedance controller, based on a magnitude comparison between a first voltage applied to the first battery cell and a second voltage applied to the second battery cell, and
    the first voltage is obtained by multiplying a current flowing in the first battery cell by an impedance of a conductive path of the first battery cell, and the second voltage is obtained by multiplying a current flowing in the second battery cell by an impedance of a conductive path of the second battery cell.

8.  The battery control system of claim 1, wherein an upper limit and a lower limit of the first range are proportional to a magnitude of the entire current introduced into the battery control system.

9.  A battery control method comprising:

    measuring a potential difference between a first battery cell and a second battery cell connected in parallel to the first battery cell;
    determining whether a magnitude of the potential difference is included in a first range; and
    based on determining that the magnitude of the potential difference is not included in the first range, controlling one of a first impedance controller connected in series to the first battery cell and a second impedance controller connected in series to the second battery cell, so as to control a ratio by which an entire current introduced into the battery control system is distributed to the first battery cell and the second battery cell, to be included in a predetermined range.

10. The method of claim 9, wherein the first impedance controller comprises a first transistor,

the second impedance controller comprises a second transistor, and
the controlling of the ratio of distribution of the entire current to be included in the predetermined range comprises: based on determining that the magnitude of the potential difference is not included in the first range, controlling a magnitude of a first gate voltage of the first transistor or a magnitude of a second gate voltage of the second transistor.

11. An electronic device comprising:

a housing;
a first battery cell disposed in the housing;
a second battery cell disposed in the housing and connected in parallel to the first battery cell; and
a control circuit electrically connected to the first battery cell and the second battery cell, wherein the control circuit is configured to:

measure a first potential difference between the first battery cell and the second battery cell;
determine a target voltage range within which the potential difference between the first battery cell and the second battery cell is to be adjusted;
determine whether a magnitude of the measured first potential difference is included in the target voltage range; and
based on determining that the magnitude of the first potential difference is not included in the target voltage range, adjust the magnitude of the first potential difference to be included in the target voltage range, thereby controlling a ratio by which an entire current introduced into the battery control system is distributed to the first battery cell and the second battery cell, to be included in a predetermined range.

12. The electronic device of claim 11, further comprising:

a first transistor connected in series to the first battery cell; and
a second transistor connected in series to the second battery cell,
wherein the control circuit is configured to:
based on determining that the magnitude of the first potential difference is not included in the target voltage range, control a first gate voltage of the first transistor and a second gate voltage of the second transistor through a signal for controlling the first gate voltage or a signal for controlling the second gate voltage, thereby controlling a ratio by which an entire current introduced into the battery control system is distributed to the first battery cell and the second battery cell, to be included in the predetermined range.

13. The electronic device of claim 12, wherein the control circuit is configured to:
based on determining that the magnitude of the first potential difference is included in the target voltage range, initialize a signal for controlling the first gate voltage of the first transistor or a signal for controlling the second gate voltage of the second transistor.

14. The electronic device of claim 12, wherein the control circuit is configured to:
in response to alternate detection of, within a predetermined time, a case in which the magnitude of the first potential difference is greater than an upper limit of the target voltage range and a case in which the magnitude of the first potential difference is smaller than a lower limit of the target voltage range, reduce a control range of the first gate voltage or a control range of the second gate voltage.

15. The electronic device of claim 11, wherein an upper limit and a lower limit of the target voltage range are proportional to a magnitude of the entire current introduced into the first battery cell and the second battery cell.

FIG.1

FIG.2

300

| 310 | 320 | 330 |
|---|---|---|
| **Battery** | **Impedance controller** | **Control circuit** |
| 311<br>First battery cell | 321<br>First impedance controller | 331<br>First control circuit |
| 312<br>Second battery cell | 322<br>Second impedance controller | 332<br>Second control circuit |
| | | 333<br>Third control circuit |

# FIG.3

FIG.4

START

MEASURE POTENTIAL DIFFERENCE
BETWEEN FIRST BATTERY CELL AND
SECOND BATTERY CELL
510

DETERMINE TARGET VOLTAGE RANGE
520

IS MAGNITUDE
OF MEASURED POTENTIAL
DIFFERENCE INCLUDED IN
TARGET VOLTAGE
RANGE?
530

YES

INITIALIZE CONTROL SIGNAL
FOR CONTROLLING IMPEDANCE
CONTROLLER
550

NO

OUTPUT CONTROL SIGNAL
FOR CONTROLLING IMPEDANCE
CONTROLLER
540

FIG.5

FIG.6

START

701 — MEASURE POTENTIAL DIFFERENCE (ΔV) BETWEEN FIRST BATTERY CELL AND SECOND BATTERY CELL

702 — DETERMINE TARGET VOLTAGE RANGE

703 — ΔV > UPPER LIMIT OF TARGET VOLTAGE RANGE?

NO → 707 — ΔV < LOWER LIMIT OF TARGET VOLTAGE RANGE?

707 NO → 711 — INITIALIZE CONTROL STEP VOLTAGE

703 YES → 704 — IS CONTROL DIRECTION IDENTICAL TO PREVIOUS CONTROL DIRECTION?

704 NO → 706 — REDUCE MAGNITUDE OF CONTROL STEP VOLTAGE

707 YES → 708 — IS CONTROL DIRECTION IDENTICAL TO PREVIOUS CONTROL DIRECTION?

708 NO → 710 — REDUCE MAGNITUDE OF CONTROL STEP VOLTAGE

704 YES → 705 — GENERATE POSITIVE (+) CONTROL STEP VOLTAGE

708 YES → 709 — GENERATE NEGATIVE (+) CONTROL STEP VOLTAGE

712 — DETERMINE NEW GATE VOLTAGE

713 — APPLY AS GATE VOLTAGE OF IMPEDANCE CONTROLLER

FIG.7

FIG.8A

FIG.8B

FIG.8C

FIG.8D

FIG.8E

FIG.8F

FIG.8G

FIG.8H

FIG.9B

FIG.9A

## INTERNATIONAL SEARCH REPORT

| International application No. |
| --- |
| **PCT/KR2022/018891** |

**A. CLASSIFICATION OF SUBJECT MATTER**

**H02J 7/00**(2006.01)i; **G01R 31/389**(2019.01)i; **H01M 10/44**(2006.01)i; **H01M 10/42**(2006.01)i

According to International Patent Classification (IPC) or to both national classification and IPC

**B. FIELDS SEARCHED**

Minimum documentation searched (classification system followed by classification symbols)

H02J 7/00(2006.01); G01R 31/382(2019.01); G06F 1/32(2006.01); H01M 10/42(2006.01); H02J 7/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전위차(voltage difference), 전류비(current ratio), 임피던스(impedance), 트랜지스터(transistor)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2020-0101174 A (SAMSUNG ELECTRONICS CO., LTD.) 27 August 2020 (2020-08-27)<br>See paragraphs [0014]-[0106]; claims 1-15; and figures 1-9. | 1-15 |
| A | KR 10-2021-0126977 A (SAMSUNG ELECTRONICS CO., LTD.) 21 October 2021 (2021-10-21)<br>See paragraphs [0079]-[0168]; claims 1-20; and figures 4-9. | 1-15 |
| A | US 2016-0291683 A1 (MICROSOFT TECHNOLOGY LICENSING, LLC) 06 October 2016 (2016-10-06)<br>See paragraphs [0018]-[0101]; claims 1-20; and figures 1-8. | 1-15 |
| A | EP 2773014 A1 (RENESAS ELECTRONICS CORPORATION) 03 September 2014 (2014-09-03)<br>See paragraphs [0027]-[0218]; claims 1-16; and figures 1-18. | 1-15 |
| A | US 2014-0306662 A1 (LINEAR TECHNOLOGY CORPORATION) 16 October 2014 (2014-10-16)<br>See paragraphs [0057]-[0172]; claims 1-26; and figures 1-22. | 1-15 |

☐ Further documents are listed in the continuation of Box C.     ☑ See patent family annex.

| | |
| --- | --- |
| \* Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **10 March 2023** | **10 March 2023** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.

**PCT/KR2022/018891**

| Patent document cited in search report | | | Publication date (day/month/year) | Patent family member(s) | | | Publication date (day/month/year) |
|---|---|---|---|---|---|---|---|
| KR | 10-2020-0101174 | A | 27 August 2020 | CN | 113454871 | A | 28 September 2021 |
| | | | | EP | 3700047 | A2 | 26 August 2020 |
| | | | | EP | 3700047 | A3 | 28 October 2020 |
| | | | | US | 2020-0266627 | A1 | 20 August 2020 |
| | | | | WO | 2020-171377 | A1 | 27 August 2020 |
| KR | 10-2021-0126977 | A | 21 October 2021 | US | 2021-0320504 | A1 | 14 October 2021 |
| | | | | WO | 2021-210827 | A1 | 21 October 2021 |
| US | 2016-0291683 | A1 | 06 October 2016 | CN | 107534189 | A | 02 January 2018 |
| | | | | CN | 107534189 | B | 05 January 2021 |
| | | | | EP | 3278194 | A1 | 07 February 2018 |
| | | | | EP | 3278194 | B1 | 15 July 2020 |
| | | | | US | 10591979 | B2 | 17 March 2020 |
| | | | | WO | 2016-160748 | A1 | 06 October 2016 |
| EP | 2773014 | A1 | 03 September 2014 | CN | 103891094 | A | 25 June 2014 |
| | | | | CN | 103891094 | B | 12 October 2016 |
| | | | | EP | 2773014 | A4 | 07 October 2015 |
| | | | | EP | 2773014 | B1 | 03 January 2018 |
| | | | | JP | 5730401 | B2 | 10 June 2015 |
| | | | | KR | 10-1865442 | B1 | 07 June 2018 |
| | | | | KR | 10-2014-0082730 | A | 02 July 2014 |
| | | | | US | 2014-0266051 | A1 | 18 September 2014 |
| | | | | US | 9478995 | B2 | 25 October 2016 |
| | | | | WO | 2013-061461 | A1 | 02 May 2013 |
| US | 2014-0306662 | A1 | 16 October 2014 | CN | 104104130 | A | 15 October 2014 |
| | | | | EP | 2787594 | A2 | 08 October 2014 |
| | | | | EP | 2787594 | A3 | 15 April 2015 |
| | | | | JP | 2014-226029 | A | 04 December 2014 |
| | | | | KR | 10-1590532 | B1 | 02 February 2016 |
| | | | | KR | 10-2014-0121365 | A | 15 October 2014 |
| | | | | US | 9774206 | B2 | 26 September 2017 |

Form PCT/ISA/210 (patent family annex) (July 2022)